# EUROPÄISCHE PATENTSCHRIFT

(11) **EP 0 561 052 B1**
(45) Veröffentlichungstag und Bekanntmachung des Hinweises auf die Patenterteilung: **19.03.1997**
(21) Anmeldenummer: 92120937.5
(22) Anmeldetag: 09.12.1992
(51) Int. Cl.: C08G 59/68, C08G 59/70, C09J 163/00, H05K 3/46

(54) **Hochtemperaturbeständige Elektro-Laminate, Verfahren zu ihrer Herstellung und Verwendung**
Heat resistant electrolaminates, preparation and use thereof
Electrolaminés résistant à la chaleur, leur procédé de préparation et utilisation

(30) Priorität: 17.03.1992 DE 4208518
(43) Veröffentlichungstag der Anmeldung: 22.09.1993
(73) Patentinhaber: Bakelite AG, 58642 Iserlohn-Letmathe (DE)
(72) Erfinder: Böttcher, Axel, Dr., W-4230 Wesel (DE); Zehrfeld, Jürgen, Dr., W-4223 Voerde (DE)

(56) Entgegenhaltungen:
- EP-A- 0 456 603
- WO-A-91/13925
- US-A- 3 677 978
- US-A- 4 473 674

## Beschreibung

Die Erfindung betrifft neue Elektro-Laminate mit hoher Temperaturbeständigkeit, die Epoxidharze als Bindemittel enthalten.

Laminate, die als elektrische Leiterplatten einsetzbar sind, sind typisiert, wobei der Typ FR-5 die höchsten Anforderungen, insbesondere hinsichtlich der Temperaturbeständigkeit und der Flammwidrigkeit, erfüllt.

Erreicht werden diese Eigenschaften durch mit Glasgewebe (E-Glas) verstärkte Epoxidharzlaminate, wobei als Epoxidharze hochwertige, bromhaltige Harze und als Härter, speziell vorbereitete, reine Lösungen von Dicyandiamid oder Diaminodiphenylsulfon dienen.

Diese Systeme haben folgende Nachteile:

Sie enthalten toxikologisch nicht unbedenkliche Lösemittel oder -gemische (DMF) zum Auflösen der Härter. Sie benötigen lange Härtungszeiten bei hohen Temperaturen (etwa 90 min bei 170 °C), und darüberhinaus ist ein Nachtempern bei einer Temperatur oberhalb 180 °C notwendig. Durch die hohen Temperaturdifferenzen ergeben sich Verwerfungen. Es resultiert eine geringe Dimensionsstabilität und ein schlechter Verbund. Insbesondere bei mehrlagigen Leiterplatten resultieren innere und äußere Spannungen.

Demgemäß ist es Aufgabe der Erfindung, hochwertige, hochtemperaturbeständige Elektro-Laminate bereitzustellen, die diese Nachteile nicht zeigen und die die Anforderungen des Typs FR-5 erfüllen, die mit einfachen Mitteln eine Flammwidrigkeit gemäß VO erreichen lassen und die sich in wirtschaftlicher Weise herstellen lassen.

Die Lösung der Aufgabe erfolgt durch Elektro-Laminate gemäß der Ansprüche 1 bis 3 und durch ein Verfahren zu ihrer Herstellung gemäß Anspruch 4.

Es wurde gefunden, daß epoxidharzgebundene Elektro-Laminate, die als Epoxidverbindungen Glycidylether und/oder Glycidylester und 3 bis 50 Gew.-%, insbesondere 10 bis 45 Gew.-% stickstoffhaltiger Glycidylverbindungen und als Härterkomponente 0,001 bis 50 Gew.-%, bezogen auf die Epoxidverbindungen, einer Metallkomplexverbindung der allgemeinen Formeln
MLₓB_{y}, oder M [SR]ₓ B_{z} enthalten, wobei
- M ein komplexbildendes Metallion
- L ein Ligand
- SR ein Säurerestion
- B eine Lewis-Base
- x eine natürliche Zahl im Bereich von 1 bis 8
- y eine natürliche Zahl im Bereich von 1 bis 5
- z eine natürliche Zahl im Bereich von 7 bis 8
sind, die gestellten Anforderungen erfüllen.

Es ist dabei von besonderem Vorteil, daß als Epoxidverbindungen alle handelsüblichen Epoxidharze Di- und Polyglycidylester und/oder -ether eingesetzt werden können, wie sie z. B. auch aus dem Handbuch "Encyclopedia of Polymer Science and Engineering", Volume 6 (1986) bekannt sind, und daß die Anforderungen des Laminate-Typs FR-5 erfüllt werden.

Weitere Verbesserungen werden erhalten, wenn Glycidylverbindungen eingesetzt werden, die gemäß EP-A-0 263 927 durch Umsetzung von Phenolen, Aminen oder Carbonsäuren mit hochreinem Epichlorhydrin hergestellt wurden.

Erfindungsgemäß eingesetzte stickstoffhaltige Glycidylverbindungen sind Umsetzungsprodukte aus Epichlorhydrin und mindestens einer di- oder polyfunktionellen stickstoffhaltigen Verbindung. Beispiele hierfür sind Polyglycidylverbindungen von polymeren Amiden oder Sulfonamiden, von Cyanursäure, Melaminen, Aminophenolen, Aminen oder Polyaminen.

Bevorzugte Amine sind Dodecylhydro-1,4,7,9'-tetraazaphenalen, Anilin, Xylylendiamine, p-Phenylendiamin, insbesondere aber 4,4'-Diaminodiphenylsulfon.

Die Herstellung entsprechender Epoxidverbindungen erfolgt in an sich bekannter Weise, wie sie z. B. auch in Lee und Neville, Handbook of Epoxy Resins, McGraw-Hill Book Company (1967) beschrieben ist.

Die bevorzugten Epoxidverbindungen sind Tetraglycidyl-methylendianilin (TGMDA) und Tetraglycidyl-diaminodiphenylsulfon (TGDDS).

Die als Härterkomponenten eingesetzten Komplexverbindungen sind aus WO 91/13925 bekannt. Durch Vermischen der Epoxid- mit der Härterkomponente entstehen Bindemittel, die bei Raumtemperatur nahezu unbegrenzt lager- und gebrauchsfähig sind, und die erst oberhalb einer Anspringtemperatur aushärten. Dies schafft einen weiteren Vorteil des erfindungsgemäß eingesetzten Bindemittels, daß es als latentes Einkomponentensystem eingesetzt werden kann. Den Bindemitteln können weitere Zusatzstoffe, insbesondere flammhemmende Zusätze, wie Phosphor, Phosphor- oder Melaminverbindungen, insbesondere Melaminphosphat in einer Menge von bis zu 50 Gew.-%, bezogen auf das Imprägniermittel, zugegeben werden. Dadurch läßt sich die Flammfestigkeit wesentlich verbessern, so daß entsprechende, mit diesem Imprägniermitteln hergestellte Laminate den Anforderungen FR-5 VO entsprechen.

Durch Wahl der Metallionen, Liganden, Säurereste und Lewis-Basen kann, wie aus WO 91/13925 bekannt, die Härterkomponente hinsichtlich ihrer Anspringtemperatur und Härtungsgeschwindigkeit gezielt eingestellt werden, so daß auch sehr kurze Härtungszeiten einstellbar sind.

Dadurch sind die erfindungsgemäßen Elektro-Laminate sowohl mit dem bislang gängigsten Verfahren, der diskontinuierlichen Verpressung der Prepregs bei einer bestimmten Temperatur in Mehrlagenpressen herstellbar, als auch in einem kontinuierlichen Verfahren in einer Doppelbandpresse, bei dem die Laminate mit einer Geschwindigkeit von bis zu 8 m/min gefertigt werden. Die Härtungstemperatur liegt dabei im Bereich von 140 bis 200 °C.

Verstärkungsmaterialien sind flächige, poröse Materialien, wie z. B. Fasermatten oder -vliese, sowie Gewebe oder Rovings auf der Basis hochwertiger Faserrohstoffe, wie z. B. Glas-, Keramik-, Bor-, Aramid- oder Phenolharzfasern.

Bevorzugtes Verstärkungsmaterial ist Glasgewebe, wie z. B. US Style 7628 mit 200 g/m² Flächengewicht.

Zur Herstellung der erfindungsgemäßen Elektro-Laminate wird das Verstärkungsmaterial mit 30 bis 50 % seines Gewichtes des erfindungsgemäßen Bindemittels beharzt.

Dies geschieht üblicherweise durch Imprägnieren des Glasgewebes mit einer entsprechenden Harzlösung und durch Trocknen des sogenannten Prepregs auf einen definierten Vorhärtungsgrad.

Die erfindungsgemäß einzusetzenden Bindemittel können aber auch als sogenannte High-Solid-Systeme mit Festkörperanteilen von 90 bis 99,5 %, bzw. auch als Feststoffmischungen ggf. unter Zusatz bis zu 8 % Lösungsmittel auf Schmelzwalzen, Schmelzkalandern oder Tapeanlagen zu Glasgewebe-Prepregs verarbeitet werden.

Die so hergestellten Prepregs werden üblicherweise geschnitten, übereinander geschichtet, ggf. mit einer Metallfolie kaschiert und bei einer Temperatur oberhalb der Anspringtemperatur des Bindemittelsystems aber unterhalb der Zersetzungstemperatur des Bindemittels verpreßt.

Die Härtung erfolgt dabei beispielsweise bei
170 °C innerhalb von 2 min
140 °C innerhalb von 5 min
120 °C innerhalb von 15 min
90 °C innerhalb von 30 min.

Ohne Verwendung von Lösemitteln zum Lösen der Härter werden durch schnelle Härtung bei Temperaturen im Bereich von 60 bis 120 °C spannungsfreie, dimensionsstabile Laminate mit niedrigen Dielektrizitätskonstanten und guten elektrischen Eigenschaften erhalten, die sich als Basismaterial für elektrische Leiterplatten eignen.

### BEISPIELE

### Beispiele 1 und 2

Es werden Prepregs hergestellt durch Imprägnieren und anschließendem Trocknen von Glasgewebe (E-Glas; 200 g/m²) mit folgenden Harz/Härter-Gemischen:
1.
   - 75 Gew.-%: Diglycidylether des Tetrabrombisphenol A (70 %ig in Methylethylketon)
   - 20 Gew.-%: Tetraglycidylmethylendianilin (TGMDA)
   - 5 Gew.-%: FeSO₄ (Imidazol)₈
2.
   - 45 Gew.-%: Diglycidylether des Tetrabrombisphenol A (70 %ig in Methylethylketon)
   - 40 Gew.-%: Tetraglycidylmethylendianilin
   - 10 Gew.-%: Ni(NO₃)₂ (Imidazol)₈
   - 5 Gew.-%: Sb₂O₅
Die Prepregs haben einen Harzgehalt von 45 %. Sie sind bei Raumtemperatur mehr als 3 Monate lagerstabil.

### Beispiele 3 und 4

Jeweils 14 der Prepregs 1 und 2 werden auf einer Doppelbandpresse bei 170 °C miteinander verpreßt und gehärtet. Die erhaltenen Laminate erfüllen beide die Anforderungen für den Typ FR-5.

Die einzelnen Eigenschaften finden sich in der folgenden Aufstellung:

| **Eigenschaften** | **Laminat aus Prepregs** | |
|---|---|---|
| | **1** | **2** |
| R_{O} [Ω] Oberflächenwiderstand nach Feuchtlagerung (C96/40/92) | 2,4 ⁻ 10¹² | 2,7 ⁻ 10¹² |
| R_{D} [Ω ⁻ cm] Durchgangswiderstand nach Feuchtlagerung (C96/40/92) | 9,4 ⁻ 10¹⁴ | 1,3 ⁻ 10¹³ |
| Dk [1MHz] | 4,7 | 4,8 |
| HPCT (High Pressure Cooker Test) | > 20 s | > 20 s |
| N-Methyl-pyrolidon-Aufnahme [%] | < 0,20 | < 0,20 |
| Brennbarkeit | V 1 | V 0 |
| Tg [°C] | 166 | 195 |
| Härtungszeit [min] (keine Nachhärtung erforderlich) | 3 | 4 |

## Patentansprüche

1. Hochtemperaturbeständige Elektro-Laminate mit Epoxidverbindungen und Härtern als Bindemittel, **dadurch gekennzeichnet**, daß sie als Epoxidverbindungen Glycidylether und/oder -ester und 3 bis 50 Gew.-% stickstoffhaltiger Glycidylverbindungen und als Härterkomponente 0,001 bis 50 Gew.-%, bezogen auf die Epoxidverbindungen, einer Metallkomplexverbindung der allgemeinen Formeln
MLₓB_{y}, oder M [SR]ₓ B_{z} enthalten, wobei
- M ein komplexbildendes Metallion
- L ein Ligand
- SR ein Säurerestion
- B eine Lewis-Base
- x eine natürliche Zahl im Bereich von 1 bis 8
- y eine natürliche Zahl im Bereich von 1 bis 5
- z eine natürliche Zahl im Bereich von 7 bis 8
sind.

2. Elektro-Laminate nach Anspruch 1, **dadurch gekennzeichnet**, daß die Bindemittel 10 bis 45 Gew.-% stickstoffhaltige Glycidylverbindungen enthalten.

3. Elektro-Laminate nach den Ansprüchen 1 und 2, **dadurch gekennzeichnet**, daß die stickstoffhaltige Glycidylverbindung Tetraglycidylmethylendianilin ist.

4. Verfahren zur Herstellung von Elektro-Laminaten gemäß der Ansprüche 1 bis 3, **dadurch gekennzeichnet**, daß mit Bindemitteln gemäß Anspruch 1 hergestellte Prepregs auf einer Doppelbandpresse bei einer Temperatur im Bereich von 140 bis 200 °C miteinander verpreßt und gehärtet werden.

## Claims

1. High-temperature-resistant electrolaminates with epoxy compounds and hardeners as binders, **characterized in that** they contain glycidyl ethers and/or esters and from 3 to 50% by weight of nitrogen-containing glycidyl compounds as epoxy compounds and from 0·001 to 50% by weight, relative to the epoxy compounds, of a metal-complex compound of the general formula
MLₓB_{y} or M [SR]ₓ Bₓ
as a hardener component,
in which
- M is a complex-forming metal ion
- L is a ligand
- SR is an acid residue ion
- B is a Lewis base
- x is an integer in the range of from 1 to 8
- y is an integer in the range of from 1 to 5, and
- z is an integer in the range of from 7 to 8.

2. Electrolaminates according to Claim 1, **characterized in that** the binders contain from 10 to 45% by weight of nitrogen-containing glycidyl compounds.

3. Electrolaminates according to Claims 1 and 2, **characterized in that** the nitrogen-containing glycidyl compound is tetraglycidyl methylene dianiline.

4. A process for producing electrolaminates according to Claims 1 to 3, **characterized in that** prepregs produced with binders according to Claim 1 are pressed together and hardened on a double-band press at a temperature in the range of from 140 to 200°C.

## Revendications

1. Electrolaminés résistant aux hautes températures avec des composés époxydes et des agents durcisseurs comme liants, caractérisés en ce qu'ils contiennent en tant que composés époxydes de l'éther de glycidyle et/ou de l'ester de glycidyle et 3 à 50% en poids de composés de glycidyle contenant de l'azote et en tant que composants durcisseurs 0,001 à 50% en poids, rapportés aux composés époxydes d'un composé de complexe métallique de la formule générale MLₓB_{y}, ou M [SR]ₓ Bₓ, dans laquelle
- M un ion métallique formant un complexe
- L un ligand
- SR un ion de reste acide
- B une base de Lewis
- x un nombre entier dans la plage de 1 à 8
- y un nombre entier dans la plage de 1 à 5
- z un nombre entier dans la plage de 7 à 8.

2. Electrolaminés selon la revendication 1, caractérisés en ce que les liants contiennent 10 à 45% en poids de composés de glycidyle contenant de l'azote.

3. Electrolaminés selon les revendications 1 et 2, caractérisés en ce que le composé glycidyle contenant de l'azote est une tétraglycidylméthylène-dianiline.

4. Procédé pour la préparation d'électrolaminés selon les revendications 1 à 3, caractérisé en ce que les préimprégnés préparés avec les liants selon la revendication 1 sont compressés et durcis sur une presse à double bande à une température de la plage de 140 à 200°C et sont durcis.
